# EUROPÄISCHE PATENTSCHRIFT

(11) **EP 2 984 668 B1**
(45) Veröffentlichungstag und Bekanntmachung des Hinweises auf die Patenterteilung: **11.11.2020**
(21) Anmeldenummer: 14716358.8
(22) Anmeldetag: 10.04.2014
(51) Int. Cl.: H01H 13/12

(54) **VORRICHTUNG ZUR BEDIENUNG MEHRERER FUNKTIONEN IN EINEM KRAFTFAHRZEUG**
DEVICE FOR OPERATING MULTIPLE FUNCTIONS IN A MOTOR VEHICLE
DISPOSITIF PERMETTANT DE COMMANDER PLUSIEURS FONCTIONS DANS UN VÉHICULE À MOTEUR

(30) Priorität: 13.04.2013 DE 102013006415
(43) Veröffentlichungstag der Anmeldung: 17.02.2016
(73) Patentinhaber: KOSTAL Automobil Elektrik GmbH & Co. KG, 58513 Lüdenscheid (DE)
(72) Erfinder: BLECKMANN, Michael, 58239 Schwerte-Ergste (DE); MACHATZKE, Corinna, 58579 Schalksmühle (DE)
(74) Vertreter: Kerkmann, Detlef
(86) Internationale Anmeldenummer: PCT/EP2014/057322
(87) Internationale Veröffentlichungsnummer: WO 2014/167075

(56) Entgegenhaltungen:
- EP-A1- 2 509 087
- WO-A2-2007/053966
- DE-A1-102009 032 634
- US-A- 5 387 261

## Beschreibung

Die Erfindung betrifft eine Vorrichtung zur Bedienung mehrerer Funktionen in einem Kraftfahrzeug, mit einem Bedienelement, welches um eine Drehachse verschwenkbar gelagert ist und dadurch zwischen wenigstens zwei Positionen beweglich ist, wobei zumindest einer der Positionen eine Schaltfunktion zugeordnet ist, wobei Endabschnitte der Drehachse des Bedienelements an zwei seitlichen Lagerstellen in zwei entlang einer Hochachse ausgerichteten Langlöchern gelagert sind, wobei das Bedienelement an mindestens einer Lagerstelle bezüglich der Richtung der Hochachse zentriert gelagert ist, und wobei sich das Bedienelement auf zwei Zapfen abstützt.

Eine derartige Vorrichtung ist aus der europäischen Patentanmeldung EP 2 509 087 A1 bekannt.

Die deutsche Offenlegungsschrift DE 10 2010 024 776 A1 zeigt eine Vorrichtung, bei der ein Bedienelement um eine Drehachse verschwenkbar gelagert ist. Das Bedienelement kann insbesondere eine Schaltleiste ausbilden, die mehrere kapazitive Sensorflächen aufweist. Durch ein Verschwenken der Schaltleiste können Schaltbausteine oder Schaltkontakte betätigt und so Schaltfunktionen ausgelöst werden.

Die DE 10 2010 024 776 A1 offenbart damit das Funktionsprinzip einer Vorrichtung, welche berührungssensitive und druckbetätigbare kontaktierende Schaltelemente kombiniert. Als Schaltelemente werden insbesondere Kippschalter vorgeschlagen. Das Betätigen von Kippschaltern erfordert einen haptisch deutlichen wahrnehmbaren Betätigungsweg, der über das hebelartig wirkende Bedienelement noch vergrößert wird. Ein derartig weiter Betätigungsweg ist nicht in jedem Fall erwünscht.

Es stellte sich die Aufgabe eine entsprechende Vorrichtung zu schaffen, welche sich durch einen einfachen, kostengünstigen und zugleich stabilen mechanischen Aufbau auszeichnet und bei der das Bedienelement spielfrei und toleranzunempfindlich und zentriert gelagert ist und Zug- und/oder Druckbetätigungen mit einem nur geringen Betätigungshub erfasst.

Diese Aufgabe wird erfindungsgemäß dadurch gelöst, dass sich zwischen den vertikalen Langlöchern der seitlichen Lagerstellen eine mittlere Lagerstelle befindet, an der die Ober- und Unterseite des Bedienelements durch entlang der Hochachse ausgerichtete Zentrierabschnitte eng eingefasst und zentriert gelagert ist, und dass die Zentrierabschnitte mit Gehäuseteilen verbunden sind und die Beweglichkeit des Bedienelements in vertikaler Richtung begrenzen.

Die Kombination einer schwimmenden Lagerung des Bedienelements auf zwei Zapfen, einer vertikal zentrierenden Lagerung des Bedienelements sowie einer schwimmenden Drehlagerung des Bedienelements an zwei vertikalen Langlöchern realisiert eine Lagerung des Bedienelements, die eindeutig bestimmt, aber nicht überbestimmt ist.

Vorteilhaft ist es, wenn mindestens einer der Zapfen sich auf einem Kraftsensor abstützt. Die Verwendung mindestens eines Kraftsensors ermöglicht die Erkennung von Druckbetätigungen des Bedienelements über einen sehr kurzen Betätigungsweg, der nicht als Bewegung des Bedienelements wahrnehmbar sein muss. Durch die erfindungsgemäß ausgestaltete Lagerung ist auf vorteilhafte Weise sichergestellt, dass der mindestens eine Kraftsensor nicht unzulässig vorgespannt und außerhalb seines Messbereichs betrieben wird.

In einer besonders vorteilhaften Ausführung der Vorrichtung ist der mindestens eine Kraftsensor als ein scheibenförmiger Sensor ausgebildet, der nach einem kapazitiven Wirkprinzip funktioniert. Ein solcher, beispielsweise parallele Kondensatorscheiben aufweisender Sensor kann besonders in Betätigungsrichtung sehr kleine Abmessungen aufweisen und Kräfte über einen kurzen Betätigungsweg erfassen. Alternativ kann der Kraftsensor auch als piezoelektrischer Sensor ausgeführt sein.

Besonders vorteilhaft ist die Verwendung von zwei Kraftsensoren, die an zwei Zapfen angeordnet sind. Hierdurch wird es möglich, den Ort von betätigten Schaltflächen aufzulösen.

Äußerst vorteilhaft ist es, wenn das Bedienelement durch eine Federkraft gegen den Kraftsensor vorgespannt ist. Hierdurch kann der Kraftsensor sowohl auf das Bedienelement einwirkende Druck- als auch Zugkräfte erfassen und damit Betätigungen des Bedienelements in zwei verschiedenen Richtungen unterscheiden.

Ebenfalls vorteilhaft ist es, wenn das Bedienelement wenigstens zwei berührungssensitive kapazitive Sensorflächen aufweist, bei dem durch eine manuelle Betätigung des Bedienelements in Abhängigkeit davon, welche der Betätigungsflächen berührt wird, unterschiedliche Funktionen ausgelöst werden können. Das Bedienelement enthält dabei vorzugsweise eine Schaltleiste, die mehrere nebeneinander angeordnete kapazitive Sensorflächen, sowie eine integrierte Elektronik aufweist. Besonders vorteilhaft kann das Bedienelement im Wesentlichen durch eine Kunststoffleiste ausgebildet sein, die verschwenkbar gelagert und dabei zugleich nahezu spielfrei und toleranzunempfindlich angeordnet werden kann.

Im Folgenden soll ein Ausführungsbeispiel der Erfindung anhand der Zeichnung dargestellt und näher erläutert werden. Eine erfindungsgemäße Vorrichtung ist in den Figuren 1 und 2 grob schematisch und in den Figuren 3 bis 5 realitätsnäher dargestellt. Es zeigen:

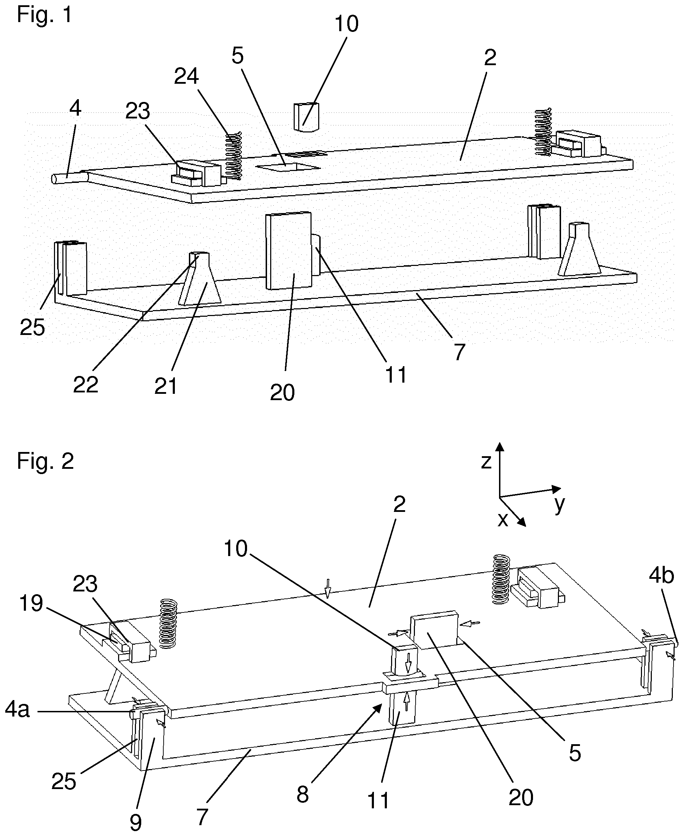

- Figur 1: eine Explosionsansicht einer Vorrichtung,
- Figur 2: die zusammengesetzte Vorrichtung,

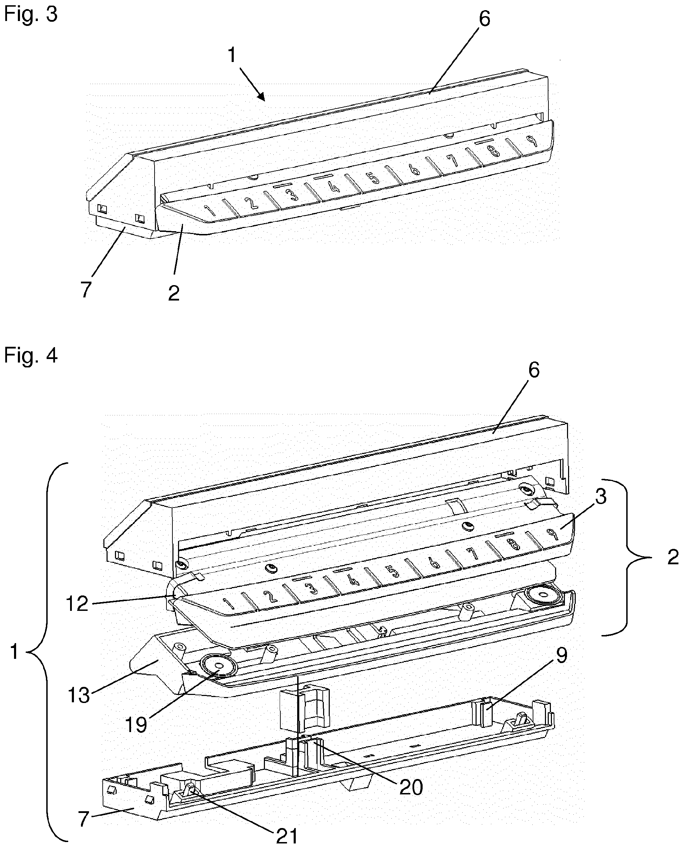

- Figur 3: die Vorrichtung als Gesamtansicht,
- Figur 4: die Vorrichtung mit geöffnetem Gehäuse,

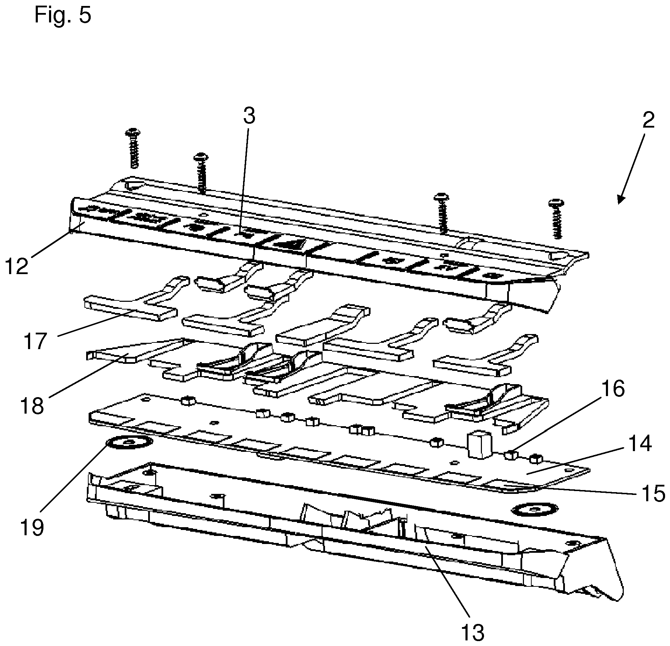

- Figur 5: ein Bedienelement in einer Explosionsansicht.

Die Figur 3 zeigt die Vorrichtung 1 im vollständig montierten Zustand; die Figur 4 stellt die Vorrichtung 1 vor dem Zusammenbau dar. Die Vorrichtung 1 besteht aus einem Gehäuseoberteil 6 und einem Gehäuseunterteil 7, zwischen denen ein Bedienelement 2 angeordnet ist. Das Gehäuseunterteil 7 weist ein angeformtes mittleres Zentrierelement 20 und zwei angeformte seitliche Lagerstellen 9 für das Bedienelement 2 auf. Erkennbar sind zudem zwei Zapfen 21, deren Endabschnitte an Kraftsensoren 19 des Bedienelements 2 zur Anlage kommen.

Den inneren Aufbau des Bedienelements 2 zeigt die Figur 5 in einer Explosionsansicht. Das Bedienelement 2 weist eine Schaltleiste 12 mit mehreren Betätigungsflächen 3 auf, die auf einen Schaltleistenträger 13 montiert ist. Zwischen der Schaltleiste 12 und dem Schaltleistenträger 13 ist eine Leiterplatte 14 angeordnet, auf der eine Reihe von kapazitiven Sensorflächen 15 platziert ist. Jeder Sensorfläche 15 ist auf der Schaltleiste 12 eine Betätigungsfläche 3 zugeordnet. Die Leiterplatte 14 trägt zudem mehrere Lichtquellen 16, die vorzugsweise als LED ausgeführt sind und deren Licht über mehrere Lichtleitkörper 17 und Blendenkörper 18 zur Beleuchtung von Symboldarstellungen zu den Betätigungsflächen 3 geleitet wird.

Unterhalb der Leiterplatte 14 sind scheibenförmige Kraftsensoren 19 angeordnet, die auf das Bedienelement 2 wirkende Betätigungskräfte erfassen und vorzugsweise nach einem kapazitiven Wirkprinzip funktionieren. Um eine Vielzahl von Bedienfunktionen ansteuerbar zu machen, kann durch Berührung einer der auf der Schaltleiste 12 angeordneten Betätigungsflächen 3, eine von mehreren auslösbaren Bedienfunktionen vorgewählt werden, welche dann durch eine Druckbetätigung des Bedienelements 2 bestätigt und ausgelöst wird.

Aufbau und Funktionsweise der erfindungsgemäßen Vorrichtung und insbesondere die Erfassung einer Betätigungskraft durch mindestens einen Kraftsensor 19 werden im Folgenden anhand der Figuren 1 und 2 in stark schematisierten Darstellungen näher erläutert. Das Bedienelement 2 ist hier vereinfacht als eine Bedienleiste 2 dargestellt, wobei zur Verdeutlichung der Mechanik auf die Darstellung sämtlicher elektrischen und elektronischen Komponenten verzichtet wurde. In den Prinzipskizzen ist zudem das Gehäuseunterteil 7 als eine Grundplatte 7 vereinfacht dargestellt. Um einen einfachen Vergleich zwischen den realitätsnahen Darstellungen der Figuren 3 bis 5 und den Prinzipdarstellungen der Figuren 1 und 2 zu ermöglichen, werden in allen Figuren für einander entsprechende Komponenten die gleichen Bezugszeichen verwendet.

Die Figuren 1 und 2 verdeutlichen die Lagerung der Bedienleiste 2 an der Grundplatte 7, welche dem Prinzip nach der Lagerung des Bedienelements 2 am Gehäuseunterteil 7 in den Figuren 3 bis 5 entspricht. Die Bedienleiste 2 ist um eine Drehachse 4 verschwenkbar an der Grundplatte 7 gelagert. Dazu sind stiftförmige Endabschnitte 4a, 4b der Drehachse 4 in vertikalen Langlöchern 25 beweglich geführt, wodurch die Lage der Bedienleiste 2 bezüglich der x-Richtung (bezogen auf die in der Figur 2 eingezeichneten Koordinatenachsen x, y, z) festlegt ist.

Zwischen den vertikalen Langlöchern 25 der seitlichen Lagerstellen 9 befindet sich eine mittlere Lagerstelle 8, an der die Ober- und Unterseite der Bedienleiste 2 durch entlang der Hochachse z ausgerichtete Zentrierabschnitte 10, 11 eng eingefasst ist. Die Zentrierabschnitte 10, 11 sind durch Teilstücke der Gehäuseteile 6, 7 ausgebildet oder mit den Gehäuseteilen 6, 7 verbunden und begrenzen die Beweglichkeit des Bedienelements 2 in vertikaler Richtung.

In die Oberfläche der Bedienleiste 2 ist eine Öffnung 5 eingebracht, in das ein mit der Grundplatte 7 verbundenes Zentrierelement 20 eingreift, welches die Beweglichkeit der Bedienleiste 2 in der y-Richtung begrenzt.
Um eine Schwenkbewegung der Bedienleiste 2 zu ermöglichen und zugleich ein Verkippen der Bedienleiste 2 um eine zur Drehachse 4 senkrechte Kippachse auszuschließen, liegt die Bedienleiste 2 schwimmend auf zwei Zapfen 21 auf. Die freien Endabschnitte 22 der Zapfen 21 sind jeweils in einer Aufnahme 23 an der Bedienleiste 2 gelagert, wobei zwischen mindestens einem Zapfen 21 und einer Anlagefläche in der Aufnahme 23 ein Kraftsensor 19 angeordnet ist.

Die vorzugsweise mehreren Kraftsensoren 19 erfassen Druckeinwirkungen, die auf die Fläche der Bedienleiste 2 einwirken, und durch die die Kraftsensoren 19 gegen die Endabschnitte 22 der Zapfen 21 gepresst werden. Die Kraftsensoren 19 können vorteilhafterweise auch Zugeinwirkungen erfassen, die durch ein Anheben der Bedienleiste 2 entstehen. Hierzu sind eine oder mehrere Federn vorgesehen, die in der Zeichnung schematisch als zwei Druckfedern 24 dargestellt sind, welche auf die Bedienleiste 2 einwirken und die Kraftsensoren19 gegen die Stirnflächen der Endabschnitte 22 der Zapfen 21 pressen. Die durch die Druckfedern 24 bewirkte Vorspannung verringert vorteilhafterweise zugleich das Lagerspiel der Bedienleiste 2.

Die Kraftsensoren 19 erfassen durch diese mechanische Vorspannung auch in der Ruheposition der Bedienleiste 2 eine Kraft, die sich bei einer Druckeinwirkung auf die Bedienleiste 2 vergrößert und bei einer Zugeinwirkung verringert. Somit können Verschwenkungen der Bedienleiste 2 sowohl nach unten wie nach oben auch ohne formschlüssige Verbindung durch die Kraftsensoren 19 erkannt werden.

Beim Überschreiten einer vorgegebenen positiven oder negativen Kraftänderungsschwelle wird durch eine hier nicht dargestellte Elektronik eine der Betätigung entsprechende Bedienfunktion ausgelöst.

### Bezugszeichen

- 1: Vorrichtung
- 2: Bedienelement (Bedienleiste)
- 3: Betätigungsflächen
- 4: Drehachse
- 4a, 4b: Endabschnitte (der Drehachse)
- 5: Öffnung
- 6: Gehäuseoberteil
- 7: Gehäuseunterteil (Grundplatte)
- 8: mittlere Lagerstelle
- 9: seitliche Lagerstellen
- 10, 11: Zentrierabschnitte
- 12: Schaltleiste
- 13: Schaltleistenträger
- 14: Leiterplatte
- 15: Sensorflächen
- 16: Lichtquellen
- 17: Lichtleitkörper
- 18: Blendenkörper
- 19: Kraftsensor(en)
- 20: Zentrierelement
- 21: Zapfen
- 22: Endabschnitte
- 23: Aufnahme
- 24: Druckfeder(n)
- 25: Langlöcher

- x, y, z: Koordinatenachsen (Richtungen)
- y: Achsenrichtung
- z: Hochachse

## Patentansprüche

1. Vorrichtung (1) zur Bedienung mehrerer Funktionen in einem Kraftfahrzeug, mit einem Bedienelement (2), welches um eine Drehachse (4) verschwenkbar gelagert ist und dadurch zwischen wenigstens zwei Positionen beweglich ist, wobei zumindest einer der Positionen eine Schaltfunktion zugeordnet ist,
wobei Endabschnitte (4a, 4b) der Drehachse (4) des Bedienelements (2) an zwei seitlichen Lagerstellen (9) in zwei entlang einer Hochachse (z) ausgerichteten Langlöchern (25) gelagert sind,
wobei das Bedienelement (2) an mindestens einer Lagerstelle (8) bezüglich der Richtung der Hochachse (z) zentriert gelagert ist, und
wobei sich das Bedienelement (2) auf zwei Zapfen (21) abstützt,
**dadurch gekennzeichnet**
**dass** sich zwischen den vertikalen Langlöchern (25) der seitlichen Lagerstellen (9) eine mittlere Lagerstelle (8) befindet, an der die Ober- und Unterseite des Bedienelements (2) durch entlang der Hochachse (z) ausgerichtete Zentrierabschnitte (10, 11) eng eingefasst und zentriert gelagert ist, und
**dass** die Zentrierabschnitte (10, 11) mit Gehäuseteilen (6, 7) verbunden sind und die Beweglichkeit des Bedienelements (2) in vertikaler Richtung begrenzen.

2. Vorrichtung nach Anspruch 1, **dadurch gekennzeichnet, dass** die Kraft, mit der sich das Bedienelement (2) auf wenigstens einen der Zapfen (21) abstützt zugleich auf einen Kraftsensor (19) einwirkt.

3. Vorrichtung nach Anspruch 1, **dadurch gekennzeichnet, dass** das Bedienelement (2) wenigstens zwei berührungssensitive kapazitive Sensorflächen (15) aufweist, die durch eine manuelle Betätigung unterschiedliche Funktionen auslösen.

4. Vorrichtung nach Anspruch 2, **dadurch gekennzeichnet, dass** der mindestens eine Kraftsensor (19) als scheibenförmiger Sensor ausgebildet ist.

5. Vorrichtung nach Anspruch 2, **dadurch gekennzeichnet, dass** der Kraftsensor (19) nach einem kapazitives Wirkprinzip funktioniert.

6. Vorrichtung nach Anspruch 2, **dadurch gekennzeichnet, dass** der Kraftsensor (19) nach einem piezoelektrischen Wirkprinzip funktioniert.

7. Vorrichtung nach Anspruch 2, **dadurch gekennzeichnet, dass** das Bedienelement (2) gegen den mindestens einen Kraftsensor (19) durch die Kraft mindestens einer Feder (24) vorgespannt ist.

8. Vorrichtung nach Anspruch 3, **dadurch gekennzeichnet, dass** das Bedienelement (2) eine Schaltleiste (12) mit mehreren kapazitiven Sensorflächen (15) ausbildet oder aufweist.

## Claims

1. A device (1) to operate several functions in a motor vehicle, with an actuating element (2) which is mounted on a rotary shaft (4) so that it can swivel and can be moved between at least two positions, with a switching function allocated to at least one of the positions,
whereby the end-sections (4a, 4b) of the rotary shaft (4) to the actuating element (2) are mounted at two lateral bearing points (9) in two slots (25) directed along an upper axis (z),
whereby the actuating element (2) is located centrally in at least one bearing point (8) in relation to the direction of the upper axis (z) and the actuating element (2) is supported on two studs (21)
**characterized by the fact, that**
between the vertical slots (25) at the lateral bearing points (9) there is a central bearing point (8), in which the upper and lower sides of the actuating element (2) is held firmly and centrally by centering pegs (10, 11) along the upper axis (z) and
the centering pegs (10, 11) are attached to parts of the housing (6, 7) and restrict movement of the actuating element (2) in a vertical direction.

2. A device as in Claim 1, **characterized by** the fact that the force with which the actuating element (2) supports at least one of the studs (21) also operates a force sensor (19) at the same time.

3. A device as in Claim 1, **characterized by** the fact that the actuating element (2) has at least two touch-sensitive capacitor surfaces (15) which are initiated by the manual actuation of different functions.

4. A device as in Claim 2, **characterized by** the fact that the force sensor (19) of which there is at least one, is formed as a disc-shaped sensor.

5. A device as in Claim 2, **characterized by** the fact that the force sensor (19) functions on a capacitive operating principle.

6. A device as in Claim 2, **characterized by** the fact that the force sensor (19) functions on a piezo-electric operating principle.

7. A device as in Claim 2, **characterized by** the fact that the actuating element (2) is pre-stressed against the force sensor (19), of which there is at least one, by the force of a spring (24), of which there is at least one.

8. A device as in Claim 3, **characterized by** the fact that the actuating element (2) forms or is made up of a strip of switches (12) with several capacitive sensor surfaces (15).

## Revendications

1. Dispositif (1) pour la commande de plusieurs fonctions dans un véhicule automobile, avec un élément de commande (2), qui est monté en pivotement autour d'un axe de rotation (4) et peut être ainsi déplacé entre au moins deux positions, sachant qu'une fonction de commutation est associée à au moins l'une des positions,
sachant que des extrémités (4a, 4b) de l'axe de rotation (4) de l'élément de commande (2) sont montées sur deux points de montage latéraux (9) dans deux trous oblongs (25) orientés le long d'un axe vertical (z),
sachant que l'élément de commande (2) est monté à au moins un point de montage (8), en étant centré en référence à la direction de l'axe vertical (z), et sachant que l'élément de commande (2) prend appui sur deux ergots (21),
**caractérisé en ce que**,
entre les trous oblongs verticaux (25) des points de montage latéraux (9), se trouve un point de montage central (8), auquel la surface supérieure et inférieure de l'élément de commande (2) et sont montées en étant étroitement serrées et centrées par des sections de centrage (10, 11) orientées le long de l'axe vertical (z), et
que les sections de centrage (10, 11) sont reliées à des pièces de boitier (6, 7) et limitent la mobilité de l'élément de commande (2) dans la direction verticale.

2. Dispositif selon la revendication 1, **caractérisé en ce que** la force, avec laquelle l'élément de commande (2) prend appui sur au moins l'un des tourillons (21) agit aussi sur un capteur de force (19).

3. Dispositif selon la revendication 1, **caractérisé en ce que** l'élément de commande (2) présente au moins deux surfaces de captage capacitives, tactiles (15), qui déclenchent des fonctions différentes par actionnement manuel.

4. Dispositif selon la revendication 2, **caractérisé en ce que** l'au moins un capteur de force (19) est réalisé en tant que capteur en forme de disque.

5. Dispositif selon la revendication 2, **caractérisé en ce que** le capteur de force (19) fonctionne selon un principe actif capacitif.

6. Dispositif selon la revendication 2, **caractérisé en ce que** le capteur de force (19) fonctionne selon un principe actif piézo-électrique.

7. Dispositif selon la revendication 2, **caractérisé en ce que** l'élément de commande (2) est précontraint contre l'au moins un capteur de force (19) par la force d'au moins un ressort (24).

8. Dispositif selon la revendication 3, **caractérisé en ce que** l'élément de commande (2) forme ou présente une baguette de commutation (12) avec plusieurs surfaces de captage capacitives (15).
